# EUROPEAN PATENT APPLICATION

(11) **EP 4 745 824 A1**
(43) Date of publication of application: **20.05.2026**
(21) Application number: 25215007.3
(22) Date of filing: 11.11.2025
(51) Int. Cl.: G06F 30/15, G06F 30/17, G06F 30/20

(54) **COMPUTER-IMPLEMENTED METHOD FOR VERIFYING A CORRECT DESIGN OF A VEHICLE MODULE**

(30) Priority: 15.11.2024 IT 202400025857
(71) Applicant: IVECO S.P.A., 10156 Torino (IT)
(72) Inventor: DUTTO, Andrea, 10156 TORINO (IT); MIROLO, Efrem, 10156 TORINO (IT); ZOCCALI, Antonio, 10156 TORINO (IT)
(74) Representative: Studio Torta S.p.A.

(57) **Abstract**

There is provided a computer-implemented method (20) for verifying the design of a vehicle module to be coupled to a vehicle. The method comprises: receiving (S1) design data indicative of a design of the vehicle module; verifying (S2) a compatibility of the vehicle module with the vehicle, based on the design data; and approving (S4) or disapproving (S7) the design of the vehicle module based on the compatibility verification.

## Description

### CROSS-REFERENCE TO RELATED APPLICATIONS

This patent application claims priority from Italian patent application no. 102024000025857 filed on November 15, 2024, the entire disclosure of which is incorporated herein by reference.

### TECHNICAL FIELD

The present invention relates to a method for verifying a correct design of a vehicle module.

In particular, the invention refers to a vehicle module to be coupled to a land vehicle for transporting people and/or goods.

### BACKGROUND ART

As is known, the design of a vehicle and its components can be long and complex.

In particular, the design of a vehicle can require considerable design and manufacturing costs for the manufacturer of such vehicle.

Therefore, there is the need to provide a method for assisting the design of a vehicle and of its components that is simple and efficient.

The object of the present invention is to satisfy the aforesaid needs in an economical and optimised manner.

### SUMMARY OF THE INVENTION

The aforesaid object is achieved by a computer-implemented method, a computer program, a data processing system and a manufacturing method, as defined in the appended claims.

### BREVE DESCRIPTION OF THE DRAWINGS

For a better understanding of the present invention, embodiments are described below by way of non-limiting example and with reference to the accompanying drawings, wherein:
- Fig. 1 shows a block diagram of a data processing system according to an embodiment; and
- Fig. 2 shows a flow chart of a method for assisting the design of a vehicle module to be coupled to a vehicle according to an embodiment.

### DETAILED DESCRIPTION OF THE INVENTION

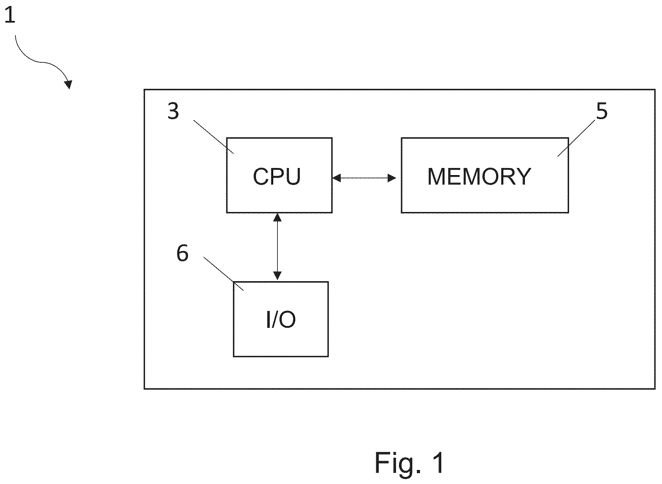

Fig. 1 shows a block diagram of a data processing system 1 configured to verify the design of a vehicle module to be coupled to a vehicle.

The data processing system 1 comprises a data processing unit 3, one or more memories 5 and input/output (I/O) interfaces 6, operatively coupled to one another.

The I/O interfaces 6 can preferably comprise a graphic interface, such as a screen, configured for the interaction with an operator.

The data processing system 1 can be formed in a single hardware system or can be a distributed data processing environment, depending on the specific application.

For example, the data processing system 1 can comprise one or more of the personal data processing devices, servers and other data processing devices, suitably coupled to one another.

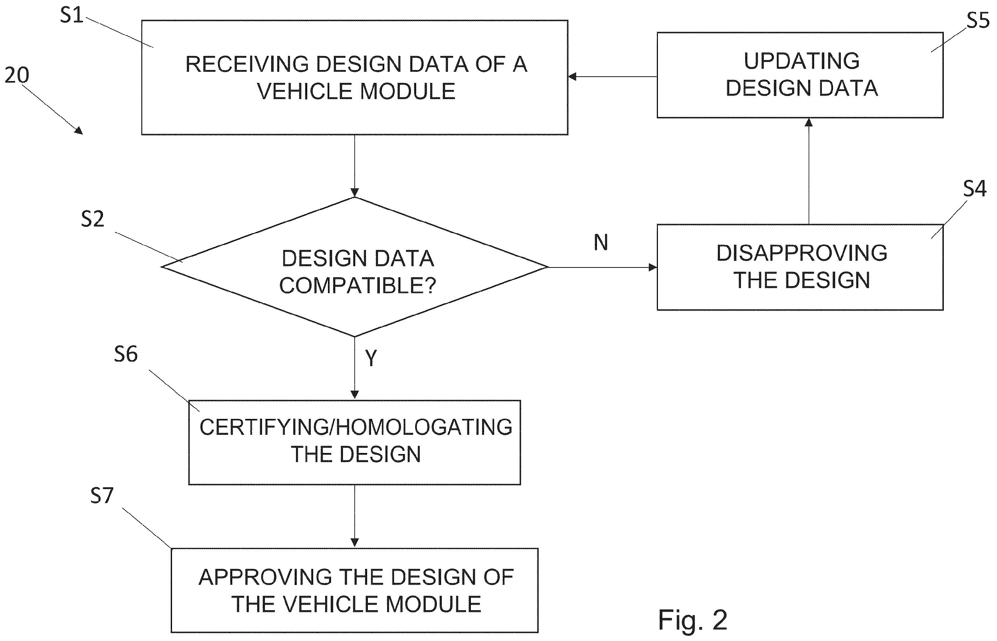

Fig. 2 shows a flow chart of a method 20 for verifying the design of a vehicle module to be coupled to a vehicle.

The method 20 allows assisting the design of the vehicle module.

The method 20 can be performed by the data processing system 1 of Fig. 1.

The vehicle module to be designed can preferably be a module for a land vehicle, for example on wheels or tracks, for transporting people and/or goods.

Preferably, the vehicle module is the vehicle module of a commercial vehicle, such as a Light Commercial Vehicle (LCV).

The vehicle module is a module that can be mounted on, integrated in and, more generally, coupled to the vehicle to perform one or more specific functions.

Purely by way of example, the vehicle module can, for example, be a dashboard of the vehicle, a platform for the dashboard of the vehicle, or an operating module of the dashboard of the vehicle; for example, the vehicle module can be an essential module of the vehicle (for example, the driving modules) or an optional module of different type configured to provide a high degree of customisation to the dashboard of the vehicle, for example in terms of function, aesthetic appearance and material.

The method 20 comprises a step S1 in which the data processing system 1 receives design data of a vehicle module to be designed.

The design data are indicative of a current design of the vehicle module.

In other words, the design data are indicative of construction parameters of the vehicle module to be designed and coupled to the vehicle.

In detail, the design data can be indicative of structural parameters of the vehicle module. For example, the design data can be indicative of one or more dimensions of the vehicle module and/or of one or more coupling elements of the vehicle module. The coupling elements can be elements, for example mechanical elements, configured to couple (for example mount, integrate, etc.) the vehicle module to the vehicle.

Additionally or alternatively, the design data can be indicative of electrical parameters of the vehicle module.

For example, the design data can be indicative of one or more electrical quantities associated to the functioning of the vehicle module, for example voltage and/or current values necessary for the functioning of the vehicle module.

Additionally or alternatively, the design data can be indicative of electronic interfaces of the vehicle module; that is, electronic interfaces of the vehicle module for data exchange between vehicle module and vehicle. For example, the electronic interfaces can be indicative of hardware and/or software peripherals for hardware/software coupling to the vehicle.

For example, the design data can be indicative of one or more software interfaces and/or hardware interfaces of the vehicle module.

The design data can be received, for example, from an external supplier, in particular from a manufacturer or designer of the vehicle module.

Subsequently, the data processing system 1 verifies (step S2) the compatibility of the vehicle module with the vehicle to which it is to be coupled, based on the design data.

In practice, in step S2 it is verified that the current design of the vehicle module is compatible with reference characteristics of the vehicle.

In step S2, the data processing system 1 can compare the design data with reference data of the vehicle. The reference data of the vehicle can have been previously stored in the memory 5.

In detail, the data processing system 1 can verify a mechanical compatibility of the vehicle module with the vehicle.

In particular, the data processing system 1 can verify that the structural parameters of the vehicle module indicated by the design data are compatible with the reference structural parameters of the vehicle.

For example, in step S2 it can be verified if one or more dimensions of the vehicle module are compatible with one or more reference dimensions of the vehicle, for example with the dimensions of the part of the vehicle in which the vehicle module is to be integrated or mounted.

Additionally or alternatively, the data processing system 1 can verify an electrical compatibility of the vehicle module with the vehicle.

In particular, the data processing system 1 can verify that the electrical parameters of the vehicle module indicated by the design data are compatible with the electrical parameters of the vehicle.

For example, in step S2 it can be verified if voltages and/or currents associated to the functioning of the vehicle module are compatible with reference voltages and/or currents associated to the functioning of the vehicle, for example depending on whether or not the vehicle is an electric vehicle.

Additionally or alternatively, the data processing system 1 can verify an electronic compatibility (i.e., hardware/software) of the vehicle module with the vehicle.

In particular, the data processing system 1 can verify that the hardware and/or software interfaces of the vehicle module indicated by the design data are compatible with the hardware and/or software interfaces of the vehicle.

For example, in step S2 it can be verified if an operating system of the vehicle module can be used with the operating system of the vehicle and/or if the hardware interfaces (for example, serial connections, etc.) of the vehicle module can be coupled with one or more hardware interfaces of the vehicle.

If the design data are not compatible with the vehicle, branch N from step S2, the data processing system 1 disapproves the current design of the vehicle module (step S4).

In detail, the data processing system 1 can provide a disapproval signal indicative of the fact that the current design is not compatible with the vehicle, so as to inform a user of the data processing system 1.

For example, the disapproval signal can be provided to the user through the I/O interface 6 and preferably can be a visual signal provided through a graphic interface of the data processing system 1.

In practice, the disapproval signal is provided during the design step of the vehicle module.

According to an embodiment, the disapproval signal can indicate the incompatibilities identified between the current design of the vehicle module and the vehicle.

In particular, the disapproval signal can indicate whether the lack of compatibility is due to one or more of the mechanical, electrical and electronic compatibilities. In this way, the user of the data processing system 1 can be made aware of the problems of compatibility between the current design and the vehicle and, hence, correct these problems of compatibility accordingly.

In response to the disapproval of the current design, a step S5 can be performed in which the current design is modified based on the disapproval signal, so as to correct the incompatibilities between the current design and the vehicle.

In detail, in step S5, new design data of the vehicle module can be generated, updated as a function of the disapproval signal and indicative of the new updated design.

Step S5 can be performed by a user of the data processing system, in particular an external supplier, for example by the manufacturer or designer of the vehicle module.

The method 20 then returns to step S1. Steps S1 to S5 can be repeated until the data processing system 1 verifies, in step S2, that the current design of the vehicle module is compatible with the vehicle.

If in step S2 the compatibility between the design data (and hence the current design) of the vehicle module and the vehicle is verified, branch S from step S2, then the data processing system 1 approves (step S7) the current design of the vehicle module.

In detail, the data processing system 1 can provide an approval signal indicative of the fact that the current design is compatible with the vehicle, so as to inform a user of the data processing system 1.

For example, the approval signal can be provided to the user through the I/O interface 6 and preferably can be a visual signal provided through a graphic interface of the data processing system 1.

In response to the approval of the current design of the vehicle module, the method 20 can continue with a further step S6 of validation of the current design, based on the design data. For example, in step S6 an approval or certification of the current design of the vehicle module according to one or more standards, according to the specific vehicle module being designed, can be verified.

Step S6, optional, can be performed before or after step S7.

Additionally, the method 20 can also comprise a further step in which the vehicle module is manufactured and/or sold, based on the current design that has been verified to be compatible with the vehicle to which the vehicle module is to be coupled.

In practice, the vehicle module can be manufactured according to the design that has been verified as compatible.

In detail, the vehicle module can be manufactured so as to comprise the characteristics indicated by the specific design that has been verified as compatible.

Manufacturing of the vehicle module is performed according to known manufacturing steps, which vary depending on the specific vehicle module.

The advantages of the present method are clearly evident from the previous description.

In fact, the present method allows verification of a correct design of a vehicle module to be coupled to a vehicle, i.e., that the design of the vehicle module is compatible with the vehicle in which the vehicle module is to be coupled. In practice, by performing a preliminary verification of the compatibility between the vehicle module and the vehicle, prior to the actual manufacture of the vehicle module, an efficient design method of the vehicle module can be obtained, hence with a saving of material and a saving of design and testing time.

In particular, the present method allows external suppliers, other than the manufacturer of the vehicle, to correctly design vehicle modules that can be coupled to the vehicle.

This allows an increase in the efficiency of the design process of the vehicle modules that form the vehicle.

Additionally, it is evident that this method allows simplification of vehicle maintenance and a reduction in its maintenance costs. In fact, in the case of failure or malfunctioning of a single vehicle module, the faulty vehicle module can efficiently be removed and replaced with a new one.

Finally, it is clear that modifications and variations can be made to the method and to the data processing system according to the present invention without departing from the scope of protection defined by the claims.

For example, the data processing system 1 can comprise different electronic processing resources to the data processing unit 3 and memory 5 shown; for example, it can comprise a plurality of data processing or control units and a plurality of memories. The data processing units and the memories can be arranged inside a same hardware architecture or be formed by a distributed architecture.

The steps of the present method can, for example, be executed locally or in cloud, according to the specific application.

## Claims

1. A computer-implemented method (20) for verifying the design of a vehicle module to be coupled to a vehicle, comprising:
receiving (S1) design data indicative of a design of the vehicle module;
verifying (S2) a compatibility of the vehicle module with the vehicle, based on the design data; and
approving (S4) or disapproving (S7) the design of the vehicle module based on the compatibility verification.

2. The method according to the preceding claim, wherein the design data are indicative of at least one of: structural parameters of the vehicle module, electrical parameters of the vehicle module, electronic interfaces of the vehicle module.

3. The method according to any of the preceding claims, wherein verifying a compatibility of the vehicle module with the vehicle comprises comparing the design data with reference data of the vehicle.

4. The method according to any of the preceding claims, wherein verifying a compatibility of the vehicle module with the vehicle comprises verifying a mechanical compatibility of the vehicle module with the vehicle.

5. The method according to the preceding claim, wherein the design data are indicative of one or more structural parameters of the vehicle module, for example one or more dimensions or coupling elements of the vehicle module, wherein verifying a mechanical compatibility comprises comparing the design data with reference data of the vehicle indicative of one or more structural parameters of the vehicle.

6. The method according to any of the preceding claims, wherein verifying a compatibility of the vehicle module with the vehicle comprises verifying an electrical compatibility of the vehicle module with the vehicle.

7. The method according to the preceding claim, wherein the design data are indicative of one or more electrical parameters of the vehicle module, for example one or more electrical quantity associated to the functioning of the vehicle module, wherein verifying an electrical compatibility comprises comparing the design data with reference data of the vehicle indicative of electrical parameters of the vehicle.

8. The method according to any of the preceding claims, wherein verifying a compatibility of the vehicle module with the vehicle comprises verifying an electronic compatibility of the vehicle module with the vehicle.

9. The method according to the preceding claim, wherein the design data comprise data indicative of electronic interfaces of the vehicle module, for example software interfaces or hardware interfaces of the vehicle module, wherein verifying an electronic compatibility comprises comparing the design data with reference data of the vehicle indicative of one or more electronic interfaces of the vehicle.

10. The method according to any of the preceding claims, comprising approving the design of the vehicle module in response to the verification that the vehicle module is compatible with the vehicle, wherein approving the design comprises providing a first signal indicative of the approval of the design of the vehicle module.

11. The method according to any of the preceding claims, comprising disapproving the design of the vehicle module in response to the verification that the vehicle module is not compatible with the vehicle, wherein disapproving the design comprises providing a second signal indicative of the disapproval of the design of the vehicle module.

12. The method according to the preceding claim, wherein the second signal is indicative of one or more of the incompatibilities identified between the vehicle module and the vehicle.

13. The method according to any of the preceding claims, further comprising modifying the design of the vehicle module in response to the disapproval of the design, so as that the design of the vehicle module becomes compatible with the vehicle.

14. A computer program comprising instructions that, when executed by a data processing system (1), cause the execution, by the data processing system, of the method according to any of the preceding claims.

15. A data processing system configured to perform the method according to any of claims 1-13.

16. A method for manufacturing a vehicle module to be coupled to a vehicle, comprising:
verifying a design of the vehicle module according to any of claims 1-13; and
in response to the approval of the design, manufacturing the vehicle module according to the approved design.
